Europäisches Patentamt

European Patent Office

Office européen des brevets

(11) Publication number: **0 665 492 A1**

# EUROPEAN PATENT APPLICATION

(21) Application number: **95200191.5**

(22) Date of filing: **27.01.95**

(51) Int. Cl.6: **G06F 7/58**, H03K 3/84

(30) Priority: **28.01.94 NL 9400139**

(43) Date of publication of application:
**02.08.95 Bulletin 95/31**

(84) Designated Contracting States:
**AT BE CH DE DK ES FR GB GR IE IT LI LU NL PT SE**

(71) Applicant: **Koninklijke PTT Nederland N.V.**
**P.O. Box 95321**
**NL-2509 CH The Hague (NL)**

(72) Inventor: **van Ravesteijn, Robertus Lambertus Adrianus**
**Hoekweg 46**
**NL-2275 TB Voorburg (NL)**
Inventor: **Zwartenkot, Klaas Elze**
**Koninginneweg 107**
**NL-2411 XM Bodegraven (NL)**

(54) **Pseudo-random series generator with increased frequency.**

(57) A pseudo-random generator which is provided with a number of memory elements such as flip-flop circuits and with at least two combining devices such as modulo-two adders can generate a digital pseudo-random series with an at least doubled bit frequency with respect to a pseudo-random generator which is provided with one combining device. Coupling outputs of the combining devices each to a different input of the memory elements offers the possibility of generating precisely the same digital pseudo-random series as was possible with the generator provided with one combining device, but with a doubled or even higher bit frequency.

Fig. 2

EP 0 665 492 A1

A Background of the invention

The invention relates to a generator for generating a digital pseudo-random series, comprising at least two memory elements, each to store a digital number, and a combining device provided with at least one input coupled to a memory element and an output coupled to a memory element.

Such a generator is generally known and comprises a shift register which, for example, comprises eight memory elements, and a combining device. An output of the combining device is coupled to an input of the shift register, and inputs of the combining device are each coupled to one of the eight outputs of the shift register. At each moment a result of the process of combining, by the combining device, the memory content of a number of memory elements of the shift register is thus presented to the input of the shift register, which result, in response to a subsequent clock pulse signal, is shifted into the shift register, the content of the first seven memory elements shifting up one location and the content of the eighth memory element leaving the shift register. If the coupling of the inputs of the combining device to the outputs of the shift register is chosen correctly, a digital pseudo-random series is then generated at the output of the combining device, with a sequence length of $2^8 - 1 = 255$ bits.

One of the drawbacks of such a known generator is that the minimal period of the clock pulse signal is limited, owing to delays present in the shift register, in the combining device and in intermediate couplings, as a result of which the maximally achievable bit frequency of the digital pseudo-random series to be generated is likewise limited (and is equal to the inverse value of the bit period).

B Summary of the invention

It is an object of the invention to provide a generator of the type stated in the preamble, which for a given period of the clock pulse signal generates a digital pseudo-random series with a higher bit frequency (which is therefore larger than the inverse value of the bit period).

To this end, the generator according to the invention is characterized in that the generator comprises at least one further combining device, provided with at least one input coupled to a memory element and an output coupled to a memory element.

As a result of using an additional combining device, two bits (instead of one bit) of the digital pseudo-random series are generated for each clock pulse signal, the maximally achievable bit frequency thereby being doubled. Obviously, if two additional combining devices are used, the bit frequency will be trebled etc.

The invention is based, inter alia, on the insight that, given a known generator, two bits to be generated successively can be predicted simultaneously, a first bit to be generated via a first combining device and second bit to be generated via a second combining device, the known generator needing to be adapted in order to prevent said second bit to be generated from subsequently being generated anew via the first combining device.

A first embodiment of the generator according to the invention is characterized in that the output of the further combining device is coupled to an input of a memory element, and the output of the combining device is coupled to an input of a further memory element.

This embodiment presents the option of allowing the generator according to the invention, provided with two or more combining devices, to generate precisely the same digital pseudo-random series as was possible with the known generator provided with one combining device, but with a doubled or even higher bit frequency.

A second embodiment of the generator according to the invention is characterized in that the combining devices each comprise a modulo-two adder, the memory elements each comprising a flip-flop circuit.

This embodiment provides a very simple version of the generator according to the invention.

The invention further relates to a method for increasing a number generating frequency of a generator for generating a digital pseudo-random series, which generator comprises M memory elements arranged in series, each to store a digital number, and which generator comprises one combining device, a function existing between, on the one hand, a number at time n and, on the other hand, at least one number at time n-i, with $i \geq 1$ and $M \geq 2$.

The method according to the invention is characterized in that the following steps are carried out:
- adding y-1 combining devices to the generator, where $2 \leq y$,
- generating y-1 subsequent functions between, on the one hand, a number at time $n+1$ up to and including, on the one hand, a number at time $n+y-1$ and, on the other hand, at least one number at time n-i, on the basis of writing out the function between, on the one hand, a number at time n and, on the other hand, at least one number at time n-i,

2

- splitting the M memory elements arranged in series into z separate groups of memory elements arranged in series, by adding to a subsequent group each subsequent memory element of the M memory elements arranged in series,
- coupling an output of a last combining device to an input of a first memory element of a first group and coupling at least one input of said last combining device to an output of a memory element according to a function most recently generated, and
- coupling an output of a preceding combining device to an input of a first memory element of a subsequent group and coupling at least one input of said preceding combining device to an output of a memory element according to a function preceding the function most recently generated.

The invention yet further relates to a further method for generating a digital pseudo-random series.

The further method according to the invention is characterized in that the digital pseudo-random series is generated by using M coupled memory locations which are split into z separate groups of serially coupled memory locations, with $2 \leq z \leq M$, and by use of y combining operations, y functions which can be mutually derived from one another existing between, on the one hand, a number at time n up to and including, on the one hand, a number at time $n+y$-1 and, on the other hand, at least one number at time n-i, with $i \geq 1$, a result of a last combining operation being fed to a first memory location of a first group, which last combining operation involves a content of memory locations determined by a last function, and a result of a previous combining operation being fed to a first memory location of a subsequent group, which previous combining operation involves a content of memory locations determined by a previously generated function.

Particularly in a software environment, said further method is readily applicable.


C Reference


■ Mathematical Methods of Information Transmission, K. Arbenz & J.C. Martin, Artech Home, p. 131 + 132

■ NL 9400139 (Dutch priority application)

The abovementioned reference is regarded as being incorporated by reference in the present application.


D Specific embodiment


The invention will be explained in more detail with reference to specific embodiments depicted in the figures, identical elements being indicated by corresponding reference numerals, where:

Fig. 1 shows a known generator for generating a digital pseudo-random series,

Fig. 2 shows a generator according to the invention for generating the same series with a bit frequency twice as high,

Fig. 3 shows a generator according to the invention for generating the same series with a bit frequency three times as high, and

Fig. 4 shows a generator according to the invention for generating the same series with a bit frequency four times as high.

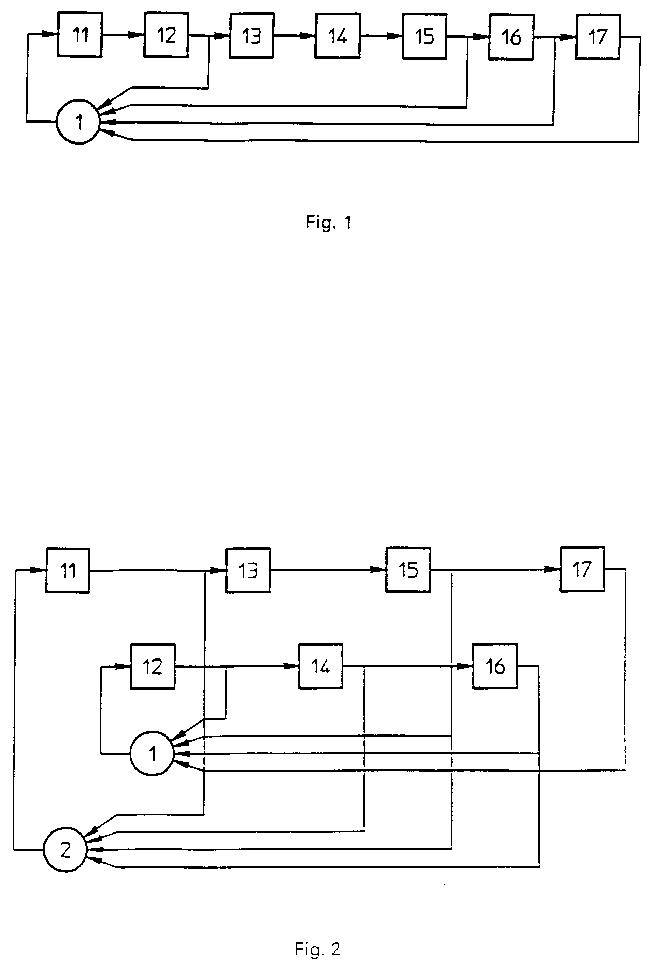

The known generator depicted in Fig. 1 consists of seven memory elements 11 to 17 inclusive arranged in series, and a combining device 1. An output of combining device 1 is coupled to an input of memory element 11, and respective inputs of combining device 1 are coupled to respective outputs of memory elements 12, 15, 16 and 17.

The generator according to the invention depicted in Fig. 2 consists of seven memory elements 11 to 17 inclusive and two combining devices 1 and 2. The seven memory elements 11 to 17 inclusive consist of two groups, a first group of four memory elements arranged in series 11, 13, 15 and 17, and a second group of three memory elements arranged in series, 12, 14 and 16. An output of combining device 1 is coupled to an input of memory element 12 of the second (in this case last) group, and respective inputs of combining device 1 are coupled to respective outputs of memory elements 12, 15, 16 and 17. An output of combining device 2 is coupled to an input of memory element 11 of the first group (in this case the group preceding the last group), and respective inputs of combining device 2 are coupled to respective outputs of memory elements 11, 14, 15 and 16.

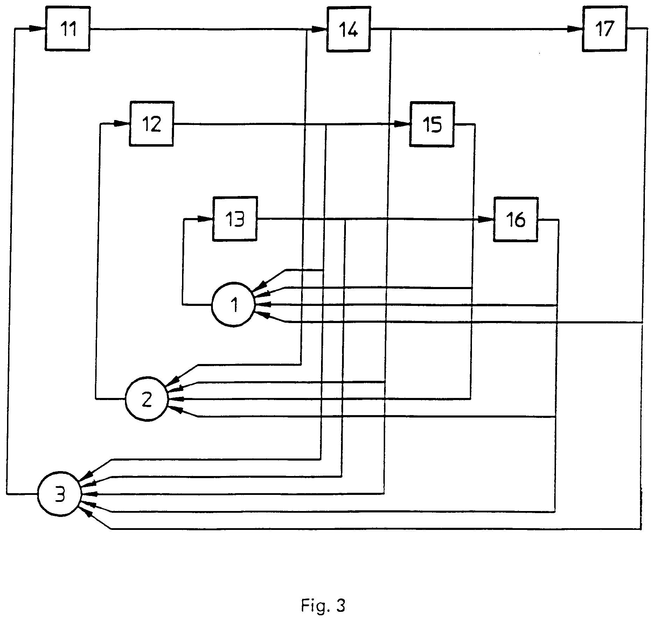

The generator according to the invention depicted in Fig. 3 consists of seven memory elements 11 to 17 inclusive and three combining devices 1, 2 and 3. The seven memory elements 11 to 17 inclusive consist of three groups, a first group of three memory elements arranged in series, 11, 14 and 17, a second group of two memory elements arranged in series, 12 and 15 and a third group of two memory elements arranged in series, 13 and 16. An output of combining device 1 is coupled to an input of memory element 13 of the third (in this case last) group, and respective inputs of combining device 1 are coupled to respective outputs of memory elements 12, 15, 16 and 17. An output of combining device 2 is coupled to an input of memory element 12 of the second group (in this case the group preceding the last group), and respective inputs of combining device 2 are coupled to respective outputs of memory elements 11, 14, 15 and 16. An output of combining device 3 is coupled to an input of memory element 11 of the first group (in this case the group preceding the third and second group), and respective inputs of combining device 3 are coupled to respective outputs of memory elements 12, 13, 14, 16 and 17.

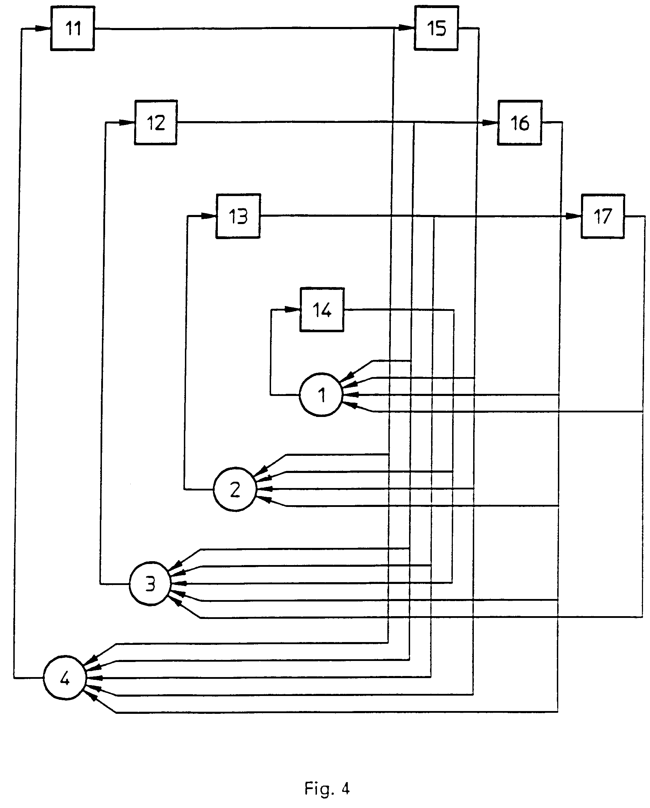

The generator according to the invention depicted in Fig. 4 consists of seven memory elements 11 to 17 inclusive and four combining devices 1, 2, 3 and 4. The seven memory elements 11 to 17 inclusive consist of four groups, a first group of two memory elements arranged in series, 11 and 15, a second group of two memory elements arranged in series, 12 and 16, a third group of two memory elements arranged in series, 13 and 17, and a fourth group of one memory element 14. An output of combining device 1 is coupled to an input of memory element 14 of the fourth (in this case last) group, and respective inputs of combining device 1 are coupled to respective outputs of memory elements 12, 15, 16 and 17. An output of combining device 2 is coupled to an input of memory element 13 of the third group (in this case the group preceding the fourth group), and respective inputs of combining device 2 are coupled to respective outputs of memory elements 11, 14, 15 and 16. An output of combining device 3 is coupled to an input of memory element 12 of the second group (in this case the group preceding the fourth and third group), and respective inputs of combining device 3 are coupled to respective outputs of memory elements 12, 13, 14, 16 and 17. An output of combining device 4 is coupled to an input of memory element 11 of the first group (in this case the group preceding the fourth and third and second group), and respective inputs of combining device 4 are coupled to respective outputs of memory elements 11, 12, 13, 15 and 16.

Memory elements 11 to 17 inclusive are, for example, flip-flop circuits such as D flip-flops, a specific series circuit of a number of flip-flop circuits being equivalent to a shift register whose length is the number of the flip-flop circuits belonging to the series circuit. Combining devices 1 to 4 inclusive are, for example, modulo-two adders.

The known generator depicted in Fig. 1 operates as follows. In the seven memory elements 11 to 17 inclusive, arranged in series, which can therefore be implemented both by seven D flip-flops and by a shift register having length seven, there are seven digital numbers such as bits. The content of memory elements 12, 15, 16 and 17 is added modulo two by combining device 1, and the result is then fed to memory element 11. Via a subsequent clock pulse, this result is loaded into memory element 11 and the content of memory element 11 is loaded into memory element 12 etc. In the process, the content of memory element 17 is therefore lost. Then the content of memory elements 12, 15, 16 and 17 is added modulo two by combining device 1, and the result is then fed to memory element 11 etc. Thus there appears, on the output of combining device 1, a digital pseudo-random series which, unless the starting content of all memory elements is identical (zero or one) has a maximum length of $2^7-1 = 127$. If the starting content of the seven memory elements 11 to 17 inclusive is, for example, 1010101, the content after one clock pulse will be 0101010, the content after two clock pulses will be 0010101, the content after three clock pulses will be 0001010, the content after four clock pulses will be 1000101, the content after five clock pulses will be 0100010, the content after six clock pulses will be 0010001, the content after seven clock pulses will be 1001000, etc. The output bits of combining device 1 are, successively, 00010010, seen from the starting content up to and including the seventh clock pulse. The output bits appearing successively at the output of combining device 1 form a maximum-length series of length 127, which is to say that the series will repeat after 127 bits.

The generator according to the invention, depicted in Fig. 2, operates as follows. In the first group of four memory elements arranged in series, 11, 13, 15 and 17, which can therefore be implemented both by means of four D flip-flops and by a shift register of length four, there are four digital numbers such as bits. In the second group of three memory elements arranged in series, 12, 14 and 16, which can therefore be implemented both by means of three D flip-flops and by a shift register of length three, there are three digital numbers such as bits. The content of memory elements 12, 15, 16 and 17 is added modulo two by combining device 1, and the result is then fed to memory element 12. Via a subsequent clock pulse, this result is loaded into memory element 12 and the content of memory element 12 is loaded into memory element 14 etc. In the process, the content of memory element 16 is therefore lost. The content of memory elements 11, 14, 15 and 16 is added to modulo two by combining device 2, and the result is then fed to memory element 11. Via the next clock pulse, this result is loaded into memory element 11 and the content of memory element 11 is loaded into memory element 13 etc. In the process, the content of memory element 17 is therefore lost. Then the content of memory elements 12, 15, 16 and 17 is added modulo two

4

by combining device 1, and the result is then fed to memory element 12 and the content of memory elements 11, 14, 15 and 16 is added modulo two by combining device 2, and the result is then fed to memory element 11, etc. Thus there appears, on the outputs of combining devices 1 and 2, a digital pseudo-random series, two bits of the series being generated, however, for each clock pulse. If the starting content of the seven memory elements 11 to 17 inclusive is, for example, 1010101, the content after one clock pulse will be 0010101, the content after two clock pulses will be 1000101, the content after three clock pulses will be 0010001, the content after four clock pulses will be 0100100, etc. The output bits of combining device 1 are, successively, 0-0-0-1, and the output bits of combining device 2 are, successively, 0-1-0-0, seen from the starting content up to and including the third clock pulse. Since two bits are now being generated for each clock pulse, the output bits of both combining devices need to be combined by inserting, between the first output bit and the second output bit of combining device 1, the first output bit of combining device 2, by inserting, between the second output bit and the third output bit of combining device 1, the second output bit of combining device 2, etc. This produces the series 00010010, which completely agrees with the series which is generated by the generator depicted in Fig. 1. By means of the generator depicted in Fig. 2, therefore, the same series is generated but in only four clock pulses instead of eight clock pulses, and thereby twice as fast. The generator depicted in Fig. 2 thus has a bit generating frequency twice as high with respect to the generator depicted in Fig. 1, if both generators are driven by means of the same clock pulses.

The generators depicted in Fig. 3 and 4, respectively, operate in a corresponding manner, with respect to the generator depicted in Fig. 1 the same series of output bits again being generated, but now three and four times, respectively, as fast. The generators depicted in Fig. 3 and 4, respectively, therefore have a bit generating frequency three and four times, respectively, as high with respect to the generator depicted in Fig. 1, if all the generators are driven by means of the same clock pulses.

The process of designing a generator according to the invention which, with respect to a given known generator, has a higher bit generating frequency while nevertheless the same series is generated (but more rapidly), proceeds as follows. The known generator depicted in Fig. 1 has seven ($M = 7$) memory elements 11 to 17 inclusive and one combining device 1. If a bit generating frequency four ($y = 4$) times as high is desired, three ($y = 4$, therefore $y-1 = 3$) combining devices 2, 3 and 4 need to be added. Of the known generator depicted in Fig. 1 there is a function between, on the one hand, a bit at time n and, on the other hand, at least one bit at time n-i, with $i \geq 1$, which can be specified as follows:

$$x_n = x_{n-2} + x_{n-5} + x_{n-6} + x_{n-7}$$

From this 3 ($y-1 = 3$) subsequent functions can be generated between, on the one hand, a bit at time $n+1$ up to and including, on the one hand, a bit at time $n+3$ ($n+y-1$) and, on the other hand, at least one bit at time n-i, on the basis of writing out the function between, on the one hand, a bit at time n and, on the other hand, at least one bit at time n-i, specifically as follows:

$$x_{n+1} = x_{n-1} + x_{n-4} + x_{n-5} + x_{n-6}$$
$$x_{n+2} = x_n + x_{n-3} + x_{n-4} + x_{n-5} = x_{n-2} + x_{n-3} + x_{n-4} + x_{n-6} + x_{n-7}$$
$$x_{n+3} = x_{n-1} + x_{n-2} + x_{n-3} + x_{n-5} + x_{n-6}$$

The seven ($M = 7$) memory elements 11 to 17 inclusive, arranged in series, in Fig. 1 need to be split into four ($z = 4$) separate groups of memory elements arranged in series, by adding to a subsequent group each subsequent memory element of the seven memory elements arranged in series. Thus a first group of two memory elements arranged in series, 11 and 15, is formed, a second group of two memory elements arranged in series, 12 and 16, is formed, a third group of two memory elements arranged in series, 13 and 17, is formed, and a fourth group of one memory element 14 is formed. Thereafter, an output of a first combining device 1 is coupled to an input of a first memory element 14 of the fourth group, and four respective inputs of said first combining device 1 are coupled to four outputs of four respective memory elements 12, 15, 16 and 17 (thus in accordance with the function associated with $x_n$), an output of a second combining device 2 is coupled to an input of a first memory element 13 of the third group, and four respective inputs of said second combining device 2 are coupled to four outputs of four respective memory elements 11, 14, 15 and 16 (thus in accordance with the function associated with $x_{n+1}$), an output of a third combining device 3 is coupled to an input of a first memory element 12 of the second group, and five respective inputs of said third combining device 3 are coupled to five outputs of five respective memory elements 12, 13, 14, 16 and 17 (thus in accordance with the function associated with $x_{n+2}$), and an output of a fourth combining device 4 is coupled to an input of a first memory element 11 of the first group, and five

5

respective inputs of said fourth combining device 4 are coupled to five outputs of five respective memory elements 11, 12, 13, 15 and 16 (thus in accordance with the function associated with $x_{n+3}$). Thus, on the basis of the known generator depicted in Fig. 1 and the requirement of the bit generating frequency to be four times as high, the generator already depicted in Fig. 4 has been designed.

As can be seen in Fig. 4, when the M memory elements arranged in series are split into z separate groups of memory elements arranged in series (by adding to a subsequent group each subsequent memory element of the M memory elements arranged in series), not every group thus produced will necessarily consist of memory elements arranged in series, it being possible instead for at least one group to consist of only one memory element. In an extreme case, where the M memory elements arranged in series are split into z = M groups, all groups will even consist of only one memory element. In an even more extreme case, the number (y) of combining devices is greater than the number (M) of memory elements, which number of memory elements (M) is then equal to the number of groups (z). In this case, of the number of combining devices (y) only a first number (M = z) of combining devices are each coupled to an input of one of the memory elements (M), and the remaining number (y-M) of the combining devices functions only as an output (together with the previously mentioned part of the combining devices).

It should be noted that the gain in speed of the generators according to the invention depicted in the Fig.s 2, 3 and 4 is achieved by presenting, for each clock pulse, two, three and four bits, respectively, in parallel instead of one bit. If a serial bit stream is required, these parallel bits can be converted, in a simple manner known to those skilled in the art, into serial bits, for example by reading the two, three and four, respectively, parallel bits into a shift register and reading them out serially at two, three and four times, respectively, as high a clock rate. To this end, the outputs of the combining devices should therefore each be coupled to an input of a different shift register. If, on the other hand, bit words are to be composed which are to be compared with other fixed words in order to simulate certain probabilities, these bit words to be composed can be generated, by means of the generators according to the invention depicted in the Fig.s 2, 3 and 4, in a manner two, three and four times, respectively, as fast. To this end, the outputs of the combining devices should each be coupled to an input on one side of a comparator, which should compare the bit word, thus fed in, with a bit word fed in at another side.

The generator according to the invention, depicted in Fig. 3, could be implemented in terms of software as follows:

```
100    m(11):=m(13):=m(15):=m(17):=1, m(12):=m(14):=m(16):=0, k:=0
110    c(1):=m(12)+m(15)+m(16)+m(17)
120    c(2):=m(11)+m(14)+m(15)+m(16)
130    c(3):=m(12)+m(13)+m(14)+m(16)+m(17)
140    for j=1 step 1 to 3 do
150    if c(j)=2 then c(j):=0
160    if c(j)=3 then c(j):=1
170    if c(j)=4 then c(j):=0
180    if c(j)=5 then c(j):=1
190    next j
200    a(k):=c(1), a(K+1):=c(2), a(k+2):=c(3)
210    k:=k+3
220    m(17):=m(14), m(14):=m(11), m(11):=c(3)
230    m(15):=m(12), m(12):=c(2)
240    m(16):=m(13), m(13):=c(1)
250    goto 110
```

In line 100, the content of the seven memory locations m(11) to m(17) inclusive is initialized, and a parameter k, needed later, is initialized. In lines 110, 120 and 130, the three outputs of the three combining operations c(1), c(2) and c(3) are calculated (added) in accordance with the previously mentioned functions without taking into account the modulo-two addition. In lines 140 to 190 inclusive, said three outputs are corrected for the modulo-two addition. In line 200, the first three output bits of the pseudo-random series to be generated are stored via a(k), a(k + 1) and a(k + 2), where k = 0, after which in line 210 the value of the parameter k is raised by three. In lines 220 to 240 inclusive, the content of memory location m(14) is then moved to memory location m(17), the content of memory location m(11) is moved to memory location m-(14), the content of memory location m(12) is moved to memory location m(15), the content of memory location m(13) is moved to memory location m(16), the output of combining operation c(1) is moved to memory location m(13), the output of combining operation c(2) is moved to memory location m(12), and the output of combining operation c(3) is moved to memory location m(11). A jump is then performed back to line 110, the whole procedure thus beginning anew.

By means of this implementation, a method for generating a digital pseudo-random series is obtained, which digital pseudo-random series is generated by using M (in this case M = 7 applies) coupled memory locations m(11) to m(17) inclusive, which are split into z (in this case z = 3 applies) separate groups of serially coupled memory locations, with $2 \leq z \leq M$, and by using y combining operations, y functions derivable from one another existing (see lines 110, 120 and 130) between, on the one hand, a number at time n up to and including, on the one hand, a number at time n + y-1 and, on the other hand, at least one number at time n-i, with $i \geq 1$, a result of a last combining operation being fed to a first memory location of a first group (see line 220), which last combining operation takes place of a content of memory locations determined by a last function (see line 130), and a result of a previous combining operation being fed to a first memory location of a subsequent group (see line 230), which previous combining operation takes place of a content of memory locations determined by a preceding function (see line 120), and a result of a yet earlier

EP 0 665 492 A1

combining operation being fed to a first memory location of a group further subsequent to the first group and next group (see line 240), which yet earlier combining operation takes place of a content of memory locations determined by a yet earlier preceding function (see line 110).

In all the specific embodiments mentioned it is the case that the number (y) of combining operations or combining devices is equal to the number (z) of groups. Previously, however, the possibility has already been mentioned of a number (y) of combining operations or combining devices which is greater than the number (z) of groups, the number (z) of groups then being equal to the number of memory elements (M). In that case, only a first number (M = z) of combining devices are each coupled to an input of a memory element, and a second number (y-M or y-z) of combining devices are used only as an output. The first number of combining devices is obviously also used as an output. Thus it is possible, for example, to generate, using eleven memory elements and sixteen combining devices, a pseudo-random series having a maximum length of $2^{11}-1 = 2047$, which is generated with sixteen parallel bits each time.

**Claims**

1.  Generator for generating a digital pseudo-random series, comprising at least two memory elements, each to store a digital number, and a combining device provided with at least one input coupled to a memory element and an output coupled to a memory element, characterized in that the generator comprises at least one further combining device, provided with at least one input coupled to a memory element and an output coupled to a memory element.

2.  Generator according to Claim 1, characterized in that the output of the further combining device is coupled to an input of a memory element, and the output of the combining device is coupled to an input of a further memory element.

3.  Generator according to Claim 1 or 2, characterized in that the combining devices each comprise a modulo-two adder, the memory elements each comprising a flip-flop circuit.

4.  Method for increasing a number generating frequency of a generator for generating a digital pseudo-random series, which generator comprises M memory elements arranged in series, each to store a digital number, and which generator comprises one combining device, a function existing between, on the one hand, a number at time n and, on the other hand, at least one number at time n-i, with $i \geq 1$ and $M \geq 2$, characterized in that the following steps are carried out:
    - adding y-1 combining devices to the generator, where $2 \leq y$,
    - generating y-1 subsequent functions between, on the one hand, a number at time n + 1 up to and including, on the one hand, a number at time n + y-1 and, on the other hand, at least one number at time n-i, on the basis of writing out the function between, on the one hand, a number at time n and, on the other hand, at least one number at time n-i,
    - splitting the M memory elements arranged in series into z separate groups of memory elements arranged in series, by adding to a subsequent group each subsequent memory element of the M memory elements arranged in series,
    - coupling an output of a last combining device to an input of a first memory element of a first group and coupling at least one input of said last combining device to an output of a memory element according to a function most recently generated, and
    - coupling an output of a preceding combining device to an input of a first memory element of a subsequent group and coupling at least one input of said preceding combining device to an output of a memory element according to a function preceding the function most recently generated.

5.  Method for generating a digital pseudo-random series, characterized in that the digital pseudo-random series is generated by using M coupled memory locations which are split into z separate groups of serially coupled memory locations, with $2 \leq z \leq M$, and by use of y combining operations, y functions which can be mutually derived from one another existing between, on the one hand, a number at time n up to and including, on the one hand, a number at time n + y-1 and, on the other hand, at least one number at time n-i, with $i \geq 1$, a result of a last combining operation being fed to a first memory location of a first group, which last combining operation involves a content of memory locations determined by a last function, and a result of a previous combining operation being fed to a first memory location of a subsequent group, which previous combining operation involves a content of memory locations

8

determined by a previously generated function.

Fig. 1

Fig. 2

Fig. 3

Fig. 4

European Patent Office

**EUROPEAN SEARCH REPORT**

Application Number

EP 95 20 0191

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| X | IEEE TRANSACTIONS ON COMPUTERS, vol. 20, no. 2, February 1971 NEW YORK US, pages 227-229, A. LEMPEL ET AL. 'High Speed Generation of Maximal Length Sequences' * section I, II * | 1-5 | G06F7/58 H03K3/84 |
| X | IBM TECHNICAL DISCLOSURE BULLETIN., vol. 11, no. 4, September 1968 NEW YORK US, pages 393-394, M. HSIAO 'GENERATING PSEUDO NOISE SEQUENCES' | 1-3 | |
| A | * the whole document * | 4,5 | |
| A | IEEE TRANSACTIONS ON COMPUTERS, vol. 23, no. 2, February 1974 NEW YORK US, pages 146-152, W. HURD 'Efficient Generation of Statistically Good Pseudonoise by Linearly Interconnected Shift Registers' * page 148, left column, line 1 - right column, line 7; figure 2 * | 4,5 | |

TECHNICAL FIELDS SEARCHED (Int.Cl.6)

G06F
H03K

The present search report has been drawn up for all claims

| Place of search | Date of completion of the search | Examiner |
|---|---|---|
| THE HAGUE | 28 April 1995 | Verhoof, P |